# EUROPEAN PATENT APPLICATION

(11) **EP 2 650 927 A1**
(43) Date of publication of application: **16.10.2013**
(21) Application number: 11847010.3
(22) Date of filing: 30.11.2011
(51) Int. Cl.: H01L 31/042, H01L 31/04

(54) **SOLAR CELL MODULE, METHOD FOR PRODUCING SOLAR CELL MODULE, SOLAR CELL, AND METHOD FOR CONNECTING TAB WIRE**

(30) Priority: 07.12.2010 JP 2010272837
(71) Applicant: Dexerials Corporation, Tokyo 141-0032 (JP)
(72) Inventor: SHIN, Yasumasa, Tokyo 141-0032 (JP); SUGA, Yasuhiro, Tokyo 141-0032 (JP)
(74) Representative: Müller - Hoffmann & Partner
(86) International application number: PCT/JP2011/077691
(87) International publication number: WO 2012/077557

(57) **Abstract**

The present invention prevents collection loss while enjoying the benefits of a solar cell having a busbarless structure. The present invention is provided with: a plurality of solar cells (2) provided with a plurality of finger electrodes (12) across the entire surface and a rear surface electrode (13) formed on the rear surface; a tab wire (3) that electrically connects adjacent solar cells (2) by being adhered across the plural finger electrodes (12) and the rear surface electrode (13); and an adhesion layer (17) that is interposed between the solar cells (2) and the tab wire (3) and that adheres the tab wire (3) to the finger electrodes (12) and the rear surface electrode (13) by means of being thermally compressed from above the tab wire (3). In the solar cells (2), across a non-thermal-compression region (2c) at which the tab wire (3) has not been thermally compressed during the adhesion process of the tab wire (3) and a thermal compression region (2b) at which the tab wire (3) has been thermally compressed in the adhesion process, a collector electrode (30) is formed so as to intersect the finger electrodes (12) formed at the non-thermal-compression region (2c).

## Description

### Field of the Invention

This invention relates to a solar cell module in which electrodes of a plurality of solar cells are connected with one after another with tab wires, a method for producing such a solar cell module, and a method for connecting the solar cells and the tab wires.
The present application asserts priority rights based on JP Patent Application 2010-272837 filed in Japan on December 7, 2010, and the total contents of disclosure of the Patent Application of the senior filing date are to be incorporated by reference into the present Application.

### Background of the Invention

In a crystal silicon-based solar cell module, a plurality of adjacent solar cells are connected to one after another by tab wires made of a ribbon-shaped copper foil or the like that are solder-coated as interconnectors. Each tab wire has its one end connected to a surface electrode of a solar cell, with the other end being connected to the rear surface electrode of an adjacent solar cell, so that the respective solar cells are series-connected to one after another. At this time, the tab wire has its one surface side of one end side adhered to the surface electrode of one solar cell, with the other surface side of the other end side being adhered to the rear surface electrode of the adjacent solar cell.

More specifically, the solar cell and the tab wire are connected to each other by connecting a busbar electrode formed on the light-receiving surface of the solar cell by a screen printing process of a silver paste, with an Ag electrode and the tab wire formed on a rear surface connection portion of the solar cell through a solder treatment (Patent Document 1). Additionally, on the region other than the connection portion of the rear surface of the solar cell, Al electrodes and Ag electrodes are formed.

However, in the case of soldering, since the connection process is carried out at a high temperature such as about 260°C, there might be a problem with connection reliability between the surface electrode of the solar cell and the rear surface electrode as well as the tab wire, due to a warp of the solar cell, an inner stress caused in the connection portion between the tab wire and the surface electrode as well as the rear surface electrode, and residues of fluxes or the like.

Therefore, conventionally, a conductive adhesive film capable of carrying out a connection process by a thermal press-bonding treatment at a comparatively low temperature is used upon connecting the surface electrode as well as the rear surface electrode and the tab wire of the solar cell (Patent Document 2). As this conductive adhesive film, spherical or scale-shaped conductive particles having an average particle diameter in the order of several *µ* ms are dispersed in a thermosetting-type binder resin composition, and this is formed into a film, and used.

After having been interpolated between the surface electrode as well as the rear surface electrode and the tab wire, the conductive adhesive film is thermally compressed by a heating bonder from above the tab wire so that its binder resin exerts flowability to be flowed out between the electrodes and the tab wire, with its conductive particles making the electrodes and the tab wire conductive to each other, and in this state the binder resin is thermally hardened. Thus, a string is formed in which the plural solar cells are series-connected to one after another by the tab wires.

The plural solar cells in which the tab wire is connected to the surface electrode and the rear surface electrode by using a conductive adhesive film is sealed by using a sealing material having translucency, such as ethylene vinyl acetate (EVA) or the like, that is interposed between a surface protective material having translucency, such as glass, a translucent plastic material or the like, and a back surface protective member, such as a film made of PET (Poly Ethylene Terephthalate) or the like.

### Prior-Art Documents

### Patent Document

PTL 1: Japanese Patent Application Laid-Open No. 2004-356349
PTL 2: Japanese Patent Application Laid-Open No. 2008-135654

### Summary of the Invention

In the production process for such a solar cell module using a conductive adhesive film, a plurality of finger electrodes, each having a width of, for example, about 50 to 200 *µ*m, are formed across the entire surface of the solar cell by application and baking process of an Ag paste, and a plurality of busbar electrodes, each having a width of, for example, 1 to 3 mm, for use in collecting an electric current collected by the respective finger electrodes are formed in a manner so as to intersect the finger electrodes. Thereafter, the tab wire is connected onto the busbar electrodes by using a conductive adhesive film so that the respective solar cells are series-connected with one after another.

In recent years, however, in order to reduce the number of production processes and also to cut the used amount of the Ag paste so as to reduce the production costs, a processing method has been proposed in which tab wires are placed so as to intersect finger electrodes with a conductive adhesive film interpolated therebetween so that the tab wires are directly adhered to the finger electrodes, without using busbar electrodes. In such a solar cell having the busbarless structure, the collecting efficiency as high as, or higher than the solar cell with the busbar electrodes formed therein can be obtained.

In this case, in the connection process of the tab wires by using the conductive adhesive film, due to generation of a stress at the time of thermally compressing the tab wires and the conductive adhesive film onto the solar cell and a difference in linear expansion coefficients between the solar cell and the tab wire or expansion and shrinkage caused by heating and cooling, a stress is applied onto the solar cell, with the result that crevices, that is, so called cell cracks, tend to occur the inside and outside of the cell. These cell cracks are mostly seen on the outside edge portions of the solar cell where the end portions of the tab wires are located.

For this reason, in order to prevent such cell cracks, a method has been taken in which the adhesion region of the tab wire onto the solar cell is offset from the outside edge portion of the solar cell toward the center side of the cell, with no tab wire being heated and compressed onto the outside edge portion of the cell.

However, since in this structure, no tab wire is adhered to the outside edge portion, in particular, in the solar cell having a busbarless structure, current collection is not available from the finger electrodes formed on the outside edge portion, resulting in a problem of a reduction of the photoelectric conversion efficiency due to the collection loss.

Therefore, an object of the present invention is to provide a solar cell module that can prevent occurrence of collection loss while enjoying the benefits of a solar cell having a busbarless structure in which the tab wire is connected by using a conductive adhesive film, to provide a photoelectric conversion efficiency that is equivalent to that of the solar cell in which the busbar electrodes are used, and also to provide a method for producing such a solar cell module, as well as a connection method for the solar cell and the tab wire.

### Summary of the Invention

In order to solve the above-mentioned problems, the solar cell module of the present invention is provided with: a plurality of solar cells each of which has a plurality of finger electrodes formed on the entire surface in parallel with one another, with a rear surface electrode being formed on a rear surface; a tab wire that electrically connects adjacent solar cells with each other by being adhered across the plural finger electrodes and the rear surface electrode; and an adhesion layer that is interpolated between the solar cells and the tab wire so that by being thermally compressed from above the tab wire, the tab wire is adhered to the finger electrodes on the solar cells and the rear surface electrode, and in this structure, each of the solar cells is provided with a collector electrode that is formed across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

Moreover, the method for producing a solar cell module of the present invention is provided with the steps of: preparing a plurality of solar cells each of which has a plurality of finger electrodes formed on the entire surface in parallel with one another, with a rear surface electrode being formed on a rear surface; disposing a tab wire on the plural finger electrodes as well as on a connection portion of the rear surface electrode with an adhesive agent interpolated therebetween; and by thermally compressing from above the tab wire, hardening the adhesive agent so that the tab wire, the finger electrodes and the rear surface electrode are connected to one another, and the method for producing a solar electrode module is further provided with a step of: preliminarily forming a collector electrode across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

Moreover the solar cell of the present invention is provided with: a plurality of finger electrodes that are formed on the entire surface thereof in parallel with one another; a rear surface electrode that is formed on a rear surface; a tab wire that is adhered across the plural finger electrodes of one of solar cells of adjacent solar cells and a connection portion the rear surface electrode of the other solar cell, and in this structure, each of the solar cells further includes an adhesion layer that is interpolated between the solar cells and the tab wire so that by being thermally compressed from above the tab wire, the tab wire is adhered to the finger electrodes on the solar cells and the rear surface electrode, and each of the solar cells is further provided a collector electrode that is formed across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

Furthermore, the method for connecting a tab wire of the present invention is provided with the steps of: preparing a plurality of solar cells each of which has a surface on which finger electrodes are formed on the entire portion thereof in parallel with one another, and a rear surface on which a rear surface electrode is formed; by thermally compressing a tab wire on the plural finger electrodes as well as on a connection portion of the rear surface electrode with an adhesive agent interpolated therebetween, the tab wire is connected thereto; and preliminarily forming a collector electrode across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

### Effects of Invention

In accordance with the present invention, since the collector electrode is formed across a region in which the tab wire is heated and compressed and a region in which the tab wire is not heated and compressed, it is possible to prevent current collection loss from the finger electrodes formed on the corresponding region, and consequently to improve the photoelectric conversion efficiency. Brief Description of Drawings
Figure 1 is an exploded perspective view showing a solar cell module.
Figure 2 is a cross-sectional view showing strings of a solar cell.
Figure 3 is a plan view that shows rear surface electrodes and connecting portions of the solar cell.
Figure 4 is a cross-sectional view showing a conductive adhesive film.
Figure 5 is a view that shows the conductive adhesive film that is wound into a reel shape.
Figure 6 is an exploded perspective view showing a solar cell to which the present invention is applied.
Figure 7 is a plane view showing a light-receiving surface of the solar cell to which the present invention is applied.
Figure 8 is a cross-sectional view that explains a formation region of a collector electrode on the solar cell to which the present invention is applied.
Figure 9 is a side view showing a process in which the conductive adhesive film and tab wire are temporarily press-bonded onto the solar cell.
Figure 10 is a side view showing a process in which the conductive adhesive film and tab wire are subjected to a main press-bonding operation onto the solar cell.

### Detailed Description of the Invention

Referring to Figures, the following description will discuss a solar cell module to which the present invention is applied, a method for producing the solar cell module and a joining method for the solar cell and tab wires, in detail.

### [Solar Cell Module]

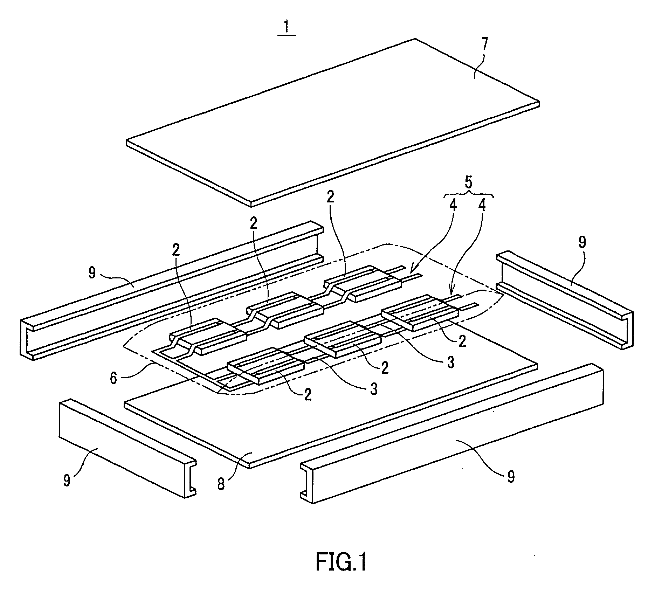

As shown in Figs. 1 to 3, a solar cell module 1 to which the present invention is applied is provided with strings 4 each of which is composed of a plurality of solar cells 2 that are connected in series with one after another by using tab wires 3 serving as interconnectors, and a matrix 5 formed by arranging a plurality of these strings 4. Moreover, the solar module 1 is formed through processes in which the matrix 5 is sandwiched by sheets 6 made of a sealing adhesive agent, and laminated together with a surface cover 7 formed on a light receiving surface side and a back sheet 8 formed on a rear surface side as one lot, and lastly a metal frame 9 made of aluminum or the like is attached on the peripheral portion thereof.

As the sealing adhesive agent, for example, a translucent sealing material, such as an ethylene vinyl acetate resin (EVA) or the like, is used. As the surface cover 7, for example, a translucent material, such as glass or a translucent plastic material, is used. As the back sheet 8, a laminate member or the like in which glass or an aluminum foil is sandwiched by resin films is used.

Each of the solar cells 2 of the solar cell module is provided with a photoelectric conversion element 10. As the photoelectric conversion element 10, various kinds of photoelectric conversion elements 10, such as a crystal silicon-based solar cell using a single crystal-type silicon photoelectric conversion element or a polycrystal-type photoelectric conversion element, and a thin-film silicon-based solar cell using a photoelectric conversion element in which a cell made of amorphous silicon and a cell made of microcrystal silicon and amorphous silicon germanium are stacked on each other, may be used.

Moreover, the photoelectric conversion element 10 is provided with finger electrodes 12 that collect electricity generated inside thereof and are formed on its light-receiving side. The finger electrodes 12 are formed through processes in which, after an Ag paste has been applied onto the surface of the solar cell 2 forming the light-receiving surface by a screen printing method or the like, a baking process is carried thereon. Moreover, the finger electrodes 12 are formed over the entire surface of the light-receiving surface as a plurality of lines, each having a width of, for example, about 50 to 200 *µ* m, that are in parallel with one another with a predetermined interval of, for example, 2 mm.

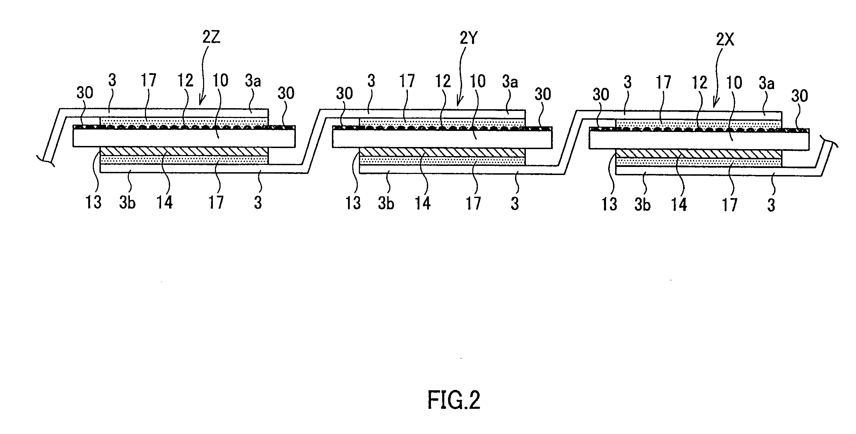

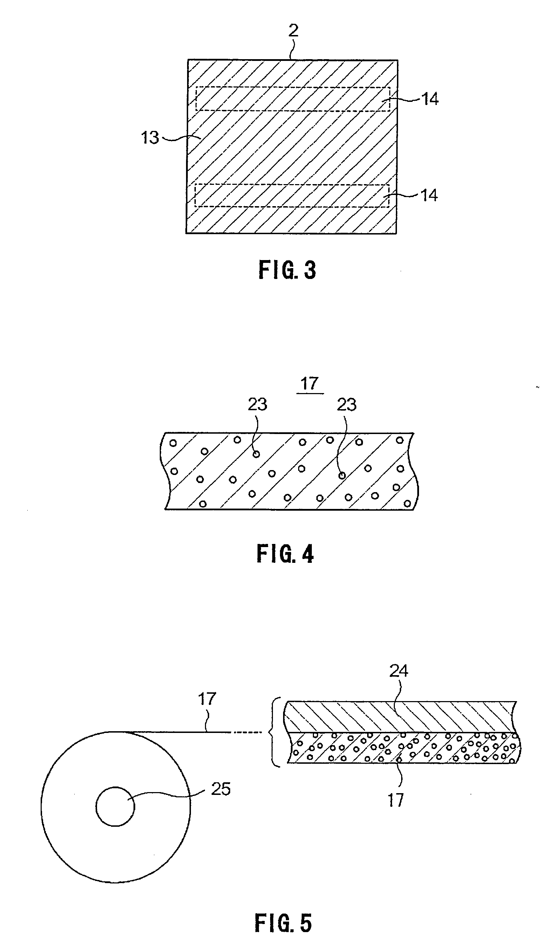

Furthermore, the photoelectric conversion element 10 is provided with a rear surface electrode 13 made of aluminum or silver, which is formed on a rear surface side opposite to the light-receiving surface. As shown in Figs. 2 and 3, the rear surface electrode 13 is prepared as an electrode made of aluminum or silver, which is formed on the rear surface of each solar cell 2 by using, for example, a screen printing method, a sputtering method, or the like. The rear surface electrode 13 has a tab wire connecting portion 14 to which the tab wire 3 is connected through a conductive adhesive film 17, which will be described later.

In each solar cell 2, the respective finger electrodes 12 formed on the surface thereof are electrically connected to the rear surface electrode 13 of an adjacent solar cell 2 by the tab wire 3 so that strings 4 that are series connected with one after another are formed. The tab wire 3, the finger electrodes 12 and the rear surface electrode 13 are connected to one another by the conductive adhesive film 17.

As shown in Fig. 2, the tab wire 3 is made of a conductive base member having an elongated shape that is used for electrically connecting adjacent solar cells 2X, 2Y and 2Z with one another, and for example, is formed by using a ribbon-shaped copper foil having virtually the same width as that of the conductive adhesive film 17 to be described later, with a thickness of, for example, 50 to 300 *µ* m, with a gold plating, silver plating, tin plating, solder plating process or the like being carried out thereon, if necessary.

### [Adhesive Film]

As shown in Fig. 4, the conductive adhesive film 17 is a thermosetting binder resin layer that contains conductive particles 23 at a high density. Moreover, from the viewpoint of the push-in characteristic, the conductive adhesive film 17 preferably has its binder resin with a lowest melt viscosity in a range from 100 to 100000 Pa·s. When the lowest melt viscosity of the conductive adhesive film 17 is too low, the resin tends to flow from a low press-bonding process to a main curing process to cause any connection failure or any protrusion onto the cell light receiving surface, resulting in a reduction in light receiving rate. Moreover, when the lowest melt viscosity is too high, a problem tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the conductive particles 23 used for the conductive adhesive film 17, examples thereof include: metal particles such as nickel, gold, silver and copper, resin particles that are subjected to gold plating or the like, and those resin particles that are subjected to gold plating, with their outermost layer being coated with an insulating material. Moreover, by allowing flat flake-shaped metal particles to be contained as the conductive particles 23, the number of mutually overlapped conductive particles 23 is increased, making it possible to ensure good conduction reliability.

Moreover, the conductive adhesive film 17 preferably has a viscosity in a range from 10 to 10000 kPa·s, and more preferably, from 10 to 5000 kPa·s, at about normal temperature. By setting the viscosity of the conductive adhesive film 17 in the range from 10 to 10000 kPa·s, it becomes possible to prevent so-called protrusion at the time when the conductive adhesive film 17 is wound into a reel shape as a tape, and also to maintain a predetermined tacking strength.

Although not particularly limited as long as the above-mentioned characteristics are not impaired, the composition of a binder resin layer of the conductive adhesive film 17 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is approximately set to 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., a phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, and any of these may be used. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present specification, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 5 is a view that schematically shows one example of a product mode of the conductive adhesive film 17. The conductive adhesive film 17 has a structure in which a binder resin layer is stacked on a peeling base member 24, and is molded into a tape shape. This tape-shaped conductive adhesive film is wound around and stacked on a reel 25, with the peeling base member 24 being located on the peripheral side. As the peeling base member 24, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesive film 17 may have a structure in which a transparent cover film is formed on a binder resin layer.

At this time, as a cover film to be pasted onto the binder resin layer, the aforementioned tab wire 3 may be used. In this manner, by preliminarily stacking the tab wire 3 and the conductive adhesive film 17 as one integral laminate, the peeling base member 24 can be separated at the time of an actual application, and by pasting the binder resin layer of the conductive adhesive film 17 onto the connection portion 14 of the finger electrode 12 and the rear surface electrode 13, the tab wire 3 can be connected to the respective electrodes 12 and 13.

In the above description, explanations have been given by exemplifying a conductive adhesive film having a film shape; however, a paste-state conductive adhesive agent may be used without causing any problems. In the present specification, a film or paste-state adhesive agent containing conductive particles is defined as "conductive adhesive agent".

In the same manner, a film or paste-state adhesive agent without containing any conductive particles is defined as "insulating adhesive agent".

Additionally, not limited to a reel shape, the conductive adhesive film 17 may have a strip shape.

As shown in Fig. 5, in the case when the conductive adhesive film 17 is provided as a reel product on which it has been wound around, by setting the viscosity of the conductive adhesive film 17 in a range from 10 to 10000 kPa·s, it is possible to prevent the conductive adhesive film 17 from being deformed, and consequently to maintain predetermined dimensions thereof. Moreover, even in the case when the conductive adhesive film 17 has a strip shape and two or more sheets thereof are stacked, in the same manner, it is possible to prevent the deformation, and consequently to maintain predetermined dimensions thereof.

The above-mentioned conductive adhesive film 17 is prepared by dissolving conductive particles 23, a film-forming resin, a liquid-state epoxy resin, a potential curing agent and a silane coupling agent in a solvent. As the solvent, toluene, ethyl acetate, or the like, or a mixed solvent of these, may be used. The resin forming solution obtained by the dissolving process is applied onto a peeling sheet, and by evaporating the solvent, a conductive adhesive film 17 is obtained.

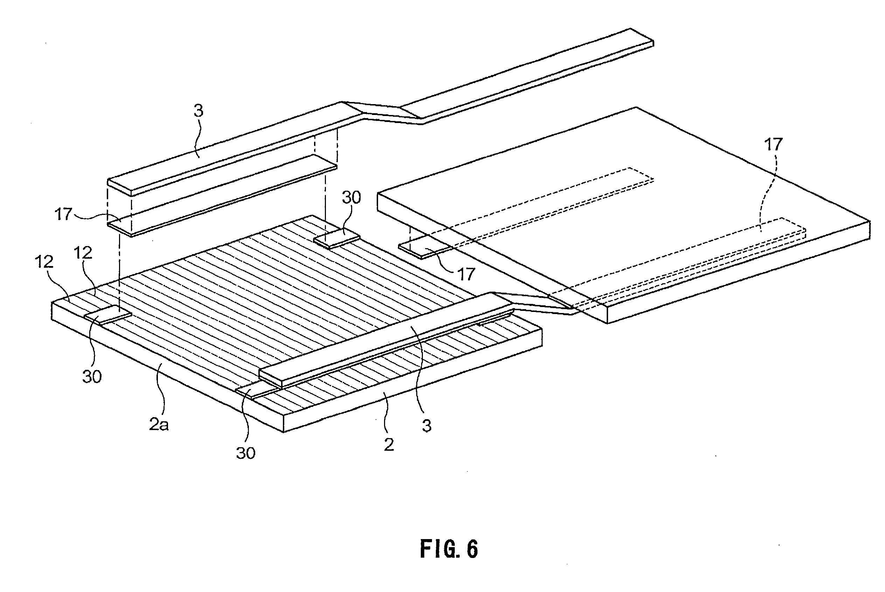

Then, the conductive adhesive film 17 is cut into predetermined lengths as two portions to be used for the surface electrode as well as two portions to be used for the rear surface electrode, and these are temporarily pasted onto predetermined positions on the surface and rear surface of a solar cell 2. At this time, as shown in Fig. 6, each conductive adhesive film 17 is temporarily pasted so as to be virtually orthogonal to a plurality of finger electrodes 12 that have been formed virtually in parallel with the surface of the solar cell 2.

In the same manner, a tab wire 3, cut into a predetermined length, is disposed on each conductive adhesive film 17 in an overlapped manner. Thereafter, the conductive adhesive film 17 is heated and compressed at predetermined temperature and pressure from above the tab wire 3 by a heating bonder so that the binder resin is hardened, with the conductive particles 23 being sandwiched between the tab wire 3 and the finger electrodes 12 or the rear surface electrode 13.
With this arrangement, the conductive adhesive film 17 allows the tab wire 3 to be adhered to each of the electrodes so as to be connected therewith for conduction.

At this time, the solar cell 2 has a structure in which in order to prevent generation of a stress at the time of thermally compressing the tab wire 3 and the conductive adhesive film 17 and subsequent so-called cell cracks caused by the stress applied onto the solar cell 2 due to a difference in linear expansion coefficients between the solar cell 2 and the tab wire 3 or expansion and shrinkage due to heating and cooling, a thermal compression region of the tab wire 3 that is exerted onto the solar cell 2 by a heating bonder is offset from the outside edge portion 2a of the solar cell 2 toward the center side of the cell.

Therefore, in the solar cell 2, since the tab wire 3 is not thermally compressed onto the outside edge portion 2a side, the finger electrodes 12 formed on the outside edge portion 2a side and the tab wire 3 are not connected with each other for conduction.

### [Configuration of Collector Electrode]

In this case, in the solar cell 2, a collector electrode 30 that is orthogonal to the finger electrodes 12 installed near the outside edge portion 2a is formed across a non-thermal-compression region 2c in which the tab wires 3 are not thermally compressed by the heating bonder and the edge portion of a thermal compression region 2b in which the tab wires 3 are thermally compressed by the heating bonder. The collector electrode 30 is formed through processes in which, for example, an Ag paste is applied to a predetermined position of the surface electrodes by a screen printing process or the like, and baked thereon. Moreover, not limited to Ag paste, any paste may be used as long as it contains a material having conductivity, such as Cu, Ni, Al or the like. In the present embodiment, the number of the collector electrodes 30 and the tab wires 3 is two; however, not limited to this, three or more of these may be used.

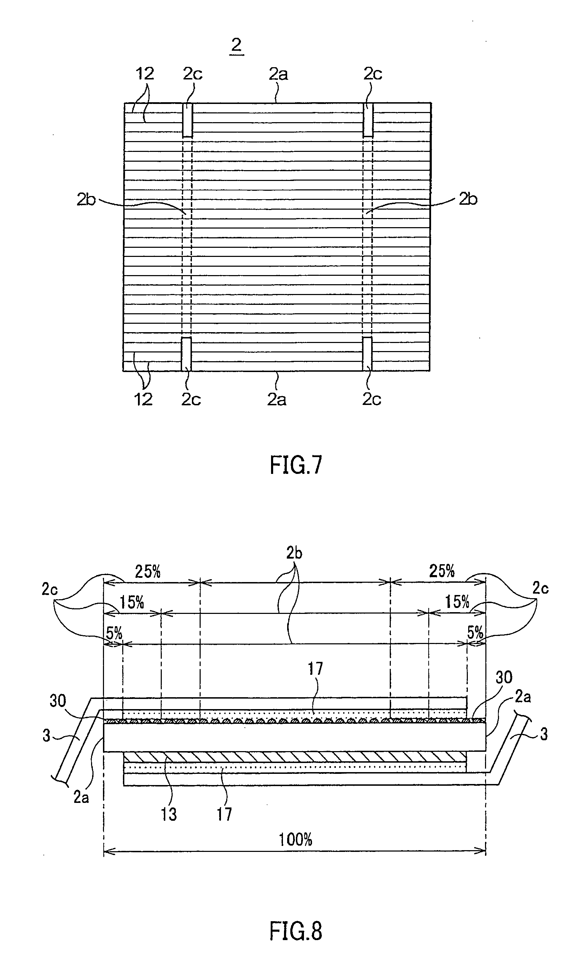

The thermal compression region 2b and the non-thermal-compression region 2c are referred to as regions located between the outside edge portions 2a that are opposed to each other on the solar cell 2 on which the conductive adhesive film 17 and the tab wires 3 are disposed and adhered to each other, and as shown in Fig. 7, within the corresponding region, the thermal compression region 2b is referred to as a region that is offset from each of the two outside edge portions 2a toward the cell inner side where a thermally compressing process of the tab wires 3 onto the solar cell 2 is carried out by the heating bonder because of prevention of cell cracks or the like, while the non-thermal-compression region 2c is referred to as a region located from the thermal compression region 2b toward each of the outside edge portion 2a sides within the corresponding region.

The collector electrode 30 is used for collecting current from the finger electrodes 12 on the non-thermal-compression region 2c in which the tab wires 3 are not thermally compressed, and is formed between the non-thermal-compression region 2c and the end portion of the thermal compression region 2b, and connected to the tab wires 3 that are bonded to the thermal compression region 2b.

With this structure, the solar cell 2 carries out current collection from the finger electrodes 12 in the thermal compression region 2b by using the tab wires 3, and also carries out current collection from the finger electrodes 12 in the non-thermal- compression region 2c by using the collector electrode 30. Therefore, the solar cell 2 makes it possible to prevent generation of current collection loss in the non-thermal- compression region 2c, and also to make the photoelectric conversion efficiency the same as or higher than that of a solar cell in which busbars are formed over the entire regions of the thermal compression region 2b and non-thermal-compression region 2c. Moreover, since the thermal compression region 2b of the tab wires 3 is offset from each of the outside edge portions toward the inner side, the solar cell 2 is free from fear of occurrence of cell cracks due to a stress applied to the outside edge of the cell. Furthermore, since the solar cell 2 makes it possible to reduce the used amount of a silver paste for use as a material for the busbar electrodes in comparison with a solar cell in which the busbar electrodes are formed over the entire regions of the thermal compression region 2b and non-thermal-compression region 2c, and consequently to reduce the production costs.

Supposing that the distance between the paired outside edge portions 2a in each of the regions 2b and 2c is 100%, the formation region of the collector electrode 30 from each of the opposed outside edge portions 2a toward the cell inner side in each of the thermal compression region 2b and the non-thermal-compression region 2c of the solar cell 2 is set to a region corresponding to 10% to 50% from each of the outside edge portions 2a of the solar cell 2 toward the cell inner side. That is, in the case when, as shown in Fig. 8, the collector electrode 30 is formed at a region 10% recessed inward from the outside edge portions 2a, it is formed at a region that is 5% recessed inward from each of the paired outside edge portions 2a. Moreover, in the case when the collector electrode 30 is formed at a region 30% recessed inward from the outside edge portions 2a, it is formed at a region that is 15% recessed inward from each of the paired outside edge portions 2a, and in the case when the collector electrode 30 is formed at a region 50% recessed inward from the outside edge portions 2a, it is formed at a region that is 25% recessed inward from each of the paired outside edge portions 2a.

As the formation area of the collector electrode 30 between the two regions 2b and 2c is reduced by 50%, by 30% and by 10%, the photoelectric conversion efficiency of the solar cell 2 is improved. This is because, in the case of 10% of the formation region of the collector electrode 30, the region is formed by about 5% from each of the outside edge portions 2a, with the rest 90% of the tab wires 3 are thermally compressed so that the finger electrodes 12 and the tab wires 3 are directly connected to each other; thus, in comparison with structures in which the collector electrode 30 is formed by 30% or by 50%, the loss can be suppressed and current is collected more effectively.

On the other hand, in the solar cell 2, as the formation area of the collector electrode 30 is increased by 10%, by 30% and by 50%, the thermal compression region 2b is contracted from the outside edge portion 2a toward the cell inner side so that it is possible to improve the durability, in particular, the durability on the outer edge portion 2a side, against a stress generated in the cell inner side during the thermal compressing process or the like.

The formation region of the collector electrode 30 is appropriately determined in accordance with the photoelectric conversion efficiency and cell strength; however, when it is formed in such a manner as to exceed 50%, the photoelectric conversion efficiency becomes as low as that of a conventional solar cell in which busbar electrodes are formed over the entire regions of the thermal compression region 2b and the non-thermal-compression region 2c, while in the case of less than 10%, since the thermal compression region 2b expands to the vicinity of the outside edge portion 2a, cell cracks might be caused.

### [Production Process]

The following description will discuss a production process of the solar cell module 1. First, a photoelectric conversion element 10 forming the solar cell 2 is prepared, and on this surface, finger electrodes 12 and collector electrodes 30 are formed at predetermined positions, with a rear surface electrode 13 being formed on the entire rear surface.

As described earlier, after an Ag paste has been applied thereon by a screen printing method or the like, a baking process is carried out thereon so that the finger electrodes 12 are formed over the entire surface of a light-receiving surface as a plurality of lines, each having a width of, for example, about 50 to 200 *µ* m, that are in parallel with one another with a predetermined interval of, for example, 2 mm. Moreover, after an Ag paste has been applied thereon by the screen printing method or the like, a baking process is carried out thereon so that each of the collector electrodes 30 is formed at a region that is 5 to 25% recessed inward of the cell from each of the outside edge portions 2a on the thermal compression region 2b and the non-thermal- compression region 2c over the end portions of the non-thermal-compression region 2c and the thermal compression region 2b in a direction virtually orthogonal to the finger electrodes 12. As the rear surface electrode 13, an electrode made of aluminum or silver is formed on the rear surface of the solar cell 2 by using, for example, a screen printing method, a sputtering method, or the like.

Next, conductive adhesive films 17 are temporarily pasted on the thermal compression region 2b and the tab wire connection portion 14 of the rear surface electrode 13 of the solar cell 2. After having been disposed on the surface and rear surface of the solar cell 2, the conductive adhesive films 17 are thermally compressed at such a temperature (for example, 40 to 60°C) as not to allow the thermo-setting reaction of the binder to proceed for a predetermined period of time (for example, 1 to 5 seconds) by a heating bonder so that they are temporarily pasted onto the solar cell 2. Additionally, at this time, by being temporarily pasted onto the thermal compression region 2b that is offset inward from each of the outside edge portions, the conductive adhesive film 17 is also temporarily pasted onto the collector electrode 30 formed over the end portions of the non-thermal-compression region 2c and the thermal compression region 2b. The solar cells 2 on each of which the conductive adhesive film 17 has been temporarily pasted are arranged in such an order as to be series-connected.

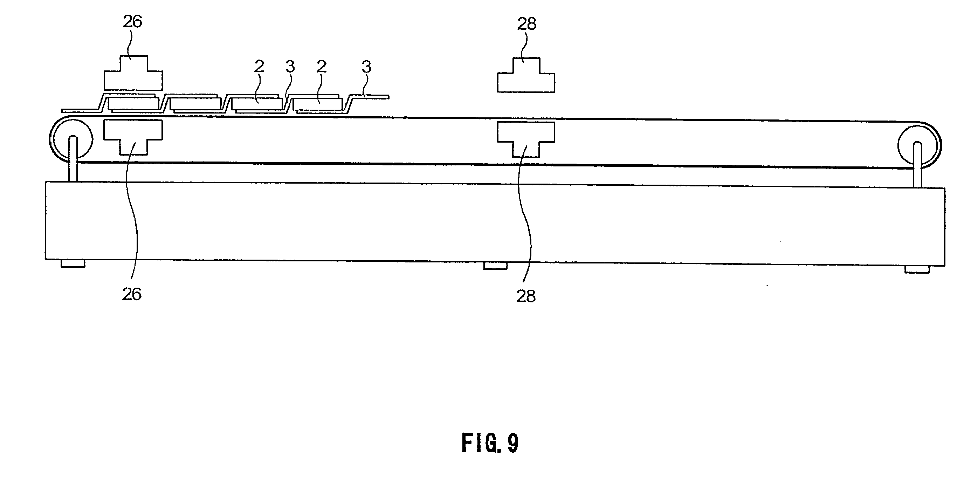

Next, onto each of the solar cells 2 that is arranged at a predetermined position opposed to a pair of upper and lower temporarily press-bonding heads 26, the tab wire 3 is temporarily press-bonded onto the conductive adhesive film 17. At this time, as shown in Figs. 2 and 9, one end 3a of the tab wire 3 is temporarily press-bonded onto an uncured conductive adhesive film 17 that has been temporarily pasted onto the surface of a proceeding solar cell 2X, and the other end 3b of the tab wire 3 is temporarily press-bonded onto the uncured conductive adhesive film 17 that has been temporarily pasted onto the connection portion 14 of the rear surface electrode 13 of another succeeding solar cell 2Y. In the same manner, onto the conductive adhesive film 17 that has been temporarily pasted onto the surface of the other solar cell 2Y as well as onto an uncured conductive adhesive film 17 that has been temporarily pasted onto the connection portion 14 of the rear surface electrode 13 of a solar cell 2Z succeeding to this solar cell 2Y, one end 3a and the other end 3b of the tab wire 3 are temporarily press-bonded. Thus, the adjacent solar cells 2 are mutually coupled in series with one after another.

The temporarily press-bonding process is carried out by the temporarily press-bonding heads 26. The temporarily press-bonding heads 26 are heated to such a temperature as not to allow the thermosetting reaction of the conductive adhesive film 17 to proceed, and compress the tab wires 3. Therefore, the conductive adhesive film 17 allows its binder resin to exert flowability and consequently have an adhesive strength so that the tab wires 3 are temporarily fixed.

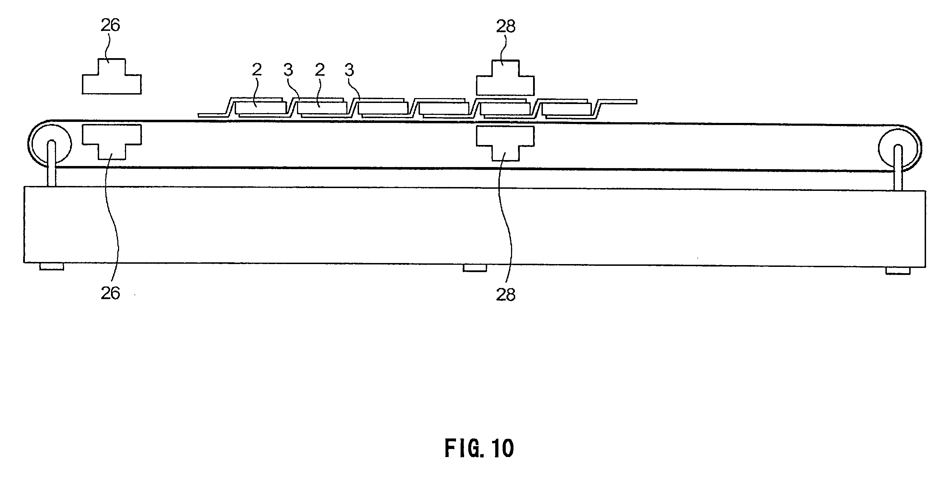

Next, as shown in Fig. 10, the plural solar cells 2 on which the tab wires 3 have been temporarily fixed are transported right below the heating press heads 28, and after having been supported thereon, the tab wires 3 are subjected to a main press-bonding process onto the respective electrodes 12, 13 and 30 of the solar cells 2 by the heating press heads 28 so that the conductive adhesive film 17 is hardened.

At this time, in the plural solar cells 2, the proceeding solar cell 2X is sandwiched between the paired heating press heads 28, which are placed at upper and lower positions and lowered and raised in synchronism with each other so that the tab wires 3 are compressed at a predetermined pressure. The heating press heads 28 are heated to a predetermined temperature at which the conductive adhesive film 17 is hardened. Therefore, the conductive adhesive film 17 has its binder resin thermally hardened so that the tab wires 3, the finger electrodes 12, the connection portions 14 of the rear electrode 13 and the collector electrode 30 are connected to one after another electrically as well as mechanically.

After the tab wires 3 have been actually press-bonded onto the proceeding solar cell 2X by the heating press heads 28, the paired heating press heads 28 are separated from the tab wires 3, and a succeeding solar cell 2Y is transported right below the paired heating press heads 28. In this manner, the solar cells 2 are transported right below the heating press heads 28 one by one so that the tab wires 3 are successively adhered to the finger electrodes 12, the connection portions 14 of the rear surface electrode 13 and the collector electrode 30, and are also series-connected to adjacent solar cells 2.

Additionally, in the present embodiment, since the connection portions 14 and the tab wires 3 are connected to each other by the conductive adhesive film 17, either of Al and Ag may be used as the rear surface electrode 13 of the solar cell 2; however, by using the Al electrode as the rear surface electrode 13, it becomes not necessary to prepare a conventionally-used Ag electrode for use in solder connection; therefore, the production process of the solar cell can be shortened, and this method is advantageous from the production engineering point of view.

Moreover, in the present embodiment, the tab wires 3 are connected to the finger electrodes 12, the connection portion 14 of the rear surface electrode 13 and the collector electrode 30 by using the conductive adhesive film 17; however, the connection may be carried out by using an insulating adhesive agent containing no conductive particles in its binder resin. In this case, the tab wires 3 are directly made in contact with the respective electrodes 12, 14 and 30 so that conduction is provided.

### Example 1

Next, with respect to examples 1 to 4 in which by using the solar cell module 1, the photoelectric conversion efficiency and the connection reliability were measured, with the formation region of the collector electrode 30 being changed, the results of measurements will be explained in comparison with a solar cell (comparative example 1) in which busbarless electrodes are formed between the outside edge portions and a solar cell (comparative example 2) having a busbarless structure.

In example 1, the formation region of the collector electrode 30 was set to 50% in the solar cell 2, in example 2, the formation region of the collector electrode 30 was set to 30% in the solar cell 2, and in example 3, the formation region of the collector electrode 30 was set to 10%, and example 4 had the same structure as that of example 2 except that as the adhesion layer for use in connecting the tab wires 3 and the solar cell 2, an insulating adhesive film (NCF: Non Conductive Film) using a binder resin containing no conductive particles was used.

In the connection reliability test, the initial largest output value (Pmax) was measured and thermal impact tests (TCT: -40°C, 3 hours ←→ 85°C, 3 hours, 200 cycles) were carried out on the respective examples and comparative examples, and the largest output value (Pmax) was again measured, and in the case when its attenuation amount was less than 3%, this case was ranked as good (○), while when its attenuation amount was 3% or more, this case was ranked as bad (×).

Moreover, the photoelectric conversion efficiency was calculated in compliance with JIS C8913 (Crystal-based Solar Cell Output Measuring Method).

**[Table 1]**

| | Example 1 | Example 2 | Example 3 | Example 4 | Comparative example 1 | Comparative example 2 |
|---|---|---|---|---|---|---|
| Conductive particles in connection film | Contained | Contained | Contained | Not contained | Contained | Contained |
| Formation region (%) of collector electrode | 50 | 30 | 10 | 30 | With busbar electrodes | Busbarless |
| Module conversion efficiency (%) | 16.77 | 16.87 | 16.96 | 16.86 | 16.78 | 16.51 |
| Connection reliability (-40°C ⇔ 85°C, 200 cycles) | ○ | ○ | ○ | ○ | ○ | × |

| | | | | | | |
|---|---|---|---|---|---|---|
| Connection reliability: Attenuation amount of largest output value (Pmax) from initial state ○: less than 3%, x: 3% or more | | | | | | |

The results of measurements are shown in Table 1. As shown in Table 1, in examples 1 to 3, the photoelectric conversion efficiency (%) tends to become higher as the formation region of the collector electrode 30 is reduced (50% < 30% < 10%). Moreover, in example 4 in which the tab wires 3 are adhered by using NCF, comparatively good photoelectric conversion efficiency is obtained.

On the other hand, in the case of the solar cell (comparative example 1) in which the busbar electrodes are formed between the outside edge portions as well, the photoelectric conversion efficiency equivalent to the respective examples is obtained. However, in comparative example 1, since the used amount of Ag paste forming the busbar electrodes increases as compared with the respective examples, this method is disadvantageous because of an increase of the production costs.

Moreover, in the solar cell (comparative example 2) having a busbarless structure, the photoelectric conversion efficiency is further lowered than those of the respective examples and comparative example 1. This is because of the fact that in comparative example 2, in order to prevent so-called cell cracks, the thermal compression region of the tab wire onto the solar cell by the heating bonder is offset from the outer edge portion toward the center side of the cell. Therefore, it is considered that in the solar cell relating to comparative example 2, since the tab wires are not heated and compressed on the outside edge portion side, the finger electrodes formed on the outside edge portion side are not conductively connected with the tab wires, resulting in collection loss from such finger electrodes.

Furthermore, in examples 1 to 4, in the connection reliability test, the attenuation amount of the largest output value (Pmax) of any of these was less than 3%, which was a good result. In contrast, in comparative example 2, the attenuation amount of the largest output value (Pmax) became 3% or more, which was a bad result.

Based upon these facts, it is found that in accordance with the present invention, since the outside edge portion of the solar cell is not compressed by the heating press head, no cell cracks occur on the outside edge portion, thereby making it possible to improve the photoelectric conversion efficiency to a level equivalent to that of the solar cell (comparative example 1) in which the busbar electrodes are formed over the entire surface of the adhesion region of the tab wires 3. In contrast, in example 2, since the solar cell having a busbarless structure is used, current collection from the finger electrodes on the outside edge portion side is not available to cause collection loss.

### Reference Signs List

1...solar cell module, 2...solar cell, 3...tab wire, 4...string, 5...matrix, 6...sheet, 7...surface cover, 8...back sheet, 9...metal frame, 10... photoelectric conversion element, 12...finger electrode, 13...rear surface electrode, 14...tab wire connection portion, 17...conductive adhesive film, 23...conductive particles, 24...peeling base member, 25...reel, 26...temporarily press-bonding head, 28...heating press head, 30...collector electrode.

## Claims

1. A solar cell module comprising:
a plurality of solar cells each of which has a plurality of finger electrodes formed on the entire surface thereof in parallel with one another, with a rear surface electrode being formed on a rear surface;
a tab wire that electrically connects adjacent solar cells with each other by being adhered across the plural finger electrodes and the rear surface electrode; and
an adhesion layer that is interpolated between the solar cells and the tab wire so that by being thermally compressed from above the tab wire, the tab wire is adhered to the finger electrodes on the solar cells and the rear surface electrode,
wherein each of the solar cells is provided with a collector electrode that is formed across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

2. The solar cell module according to claim 1, wherein the collector electrode has a formation region formed from each of outside edges opposed to each other on the solar cell that corresponds to a region of 10% to 50% from the outside edge of the solar cell inward.

3. The solar cell module according to claim 1 or 2, wherein the adhesion layer is made from a conductive adhesive agent in which conductive particles are dispersed.

4. The solar cell module according to claim 1 or 2, wherein the adhesion layer is made from an insulating adhesive agent containing no conductive particles.

5. A method for producing a solar cell module comprising the steps of:
preparing a plurality of solar cells each of which has a plurality of finger electrodes formed on the entire surface in parallel with one another, with a rear surface electrode being formed on a rear surface;
disposing a tab wire on the plural finger electrodes as well as on a connection portion of the rear surface electrode with an adhesive agent interpolated therebetween; and
by thermally compressing from above the tab wire, hardening the adhesive agent so that the tab wire, the finger electrodes and the rear surface electrode are connected to one another,
wherein the method for producing a solar electrode module further comprises a step of: preliminarily forming a collector electrode across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

6. The method for producing a solar cell module according to claim 5, wherein the collector electrode has a formation region formed from each of outside edges opposed to each other on the solar cell that corresponds to a region of 10% to 50% from the outside edge of the solar cell inward.

7. The method for producing a solar cell module according to claim 5 or 6, wherein the adhesion layer is made from a conductive adhesive agent in which conductive particles are dispersed.

8. The method for producing a solar cell module according to claim 5 or 6, wherein the adhesion layer is made from an insulating adhesive agent containing no conductive particles.

9. A solar cell comprising:
a plurality of finger electrodes that are formed on the entire surface thereof in parallel with one another;
a rear surface electrode that is formed on a rear surface;
a tab wire that is adhered across the plural finger electrodes of one of adjacent solar cells and a connection portion of the rear surface electrode of the other solar cell,
wherein each of the solar cells further comprises an adhesion layer that is interpolated between the solar cells and the tab wire so that by being thermally compressed from above the tab wire, the tab wire is adhered to the finger electrodes on the solar cells and the rear surface electrode, and
wherein each of the solar cells is provided a collector electrode that is formed across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

10. The solar cell according to claim 9, wherein the collector electrode has a formation region formed from each of outside edges opposed to each other on the solar cell that corresponds to a region of 10% to 50% from the outside edge of the solar cell inward.

11. The solar cell method according to claim 9 or 10, wherein the adhesion layer is made from a conductive adhesive agent in which conductive particles are dispersed.

12. The solar cell according to claim 9 or 10, wherein the adhesion layer is made from an insulating adhesive agent containing no conductive particles.

13. A method for connecting a tab wire comprising the steps of:
preparing a plurality of solar cells each of which has a surface on which finger electrodes are formed on the entire portion thereof in parallel with one another, and a rear surface on which a rear surface electrode is formed;
by thermally compressing a tab wire on the plural finger electrodes as well as on a connection portion of the rear surface electrode with an adhesive agent interpolated therebetween, the tab wire is connected thereto; and
preliminarily forming a collector electrode across a non-thermal-compression region in which the tab wire is not heated and compressed during the adhesion process of the tab wire and a thermal compression region in which the tab wire is heated and compressed during the adhesion process, so as to intersect the finger electrodes formed on the non-thermal-compression region.

14. The method for connecting a tab wire according to claim 13, wherein the collector electrode has a formation region formed from each of outside edges opposed to each other on the solar cell that corresponds to a region of 10% to 50% from the outside edge of the solar cell inward.

15. The method for connecting a tab wire according to claim 13 or 14, wherein the adhesion layer is made from a conductive adhesive agent in which conductive particles are dispersed.

16. The method for connecting a tab wire according to claim 13 or 14, wherein the adhesion layer is made from an insulating adhesive agent containing no conductive particles.
